# EUROPÄISCHE PATENTANMELDUNG

(11) **EP 3 595 002 A1**
(43) Veröffentlichungstag der Anmeldung: **15.01.2020**
(21) Anmeldenummer: 18183126.4
(22) Anmeldetag: 12.07.2018
(51) Int. Cl.: H01L 23/373

(54) **METALL-KERAMIK-SUBSTRAT MIT EINER ZUR DIREKTEN KÜHLUNG GEFORMTEN FOLIE ALS SUBSTRATUNTERSEITE**

(71) Anmelder: Heraeus Deutschland GmbH & Co KG, 63450 Hanau (DE)
(72) Erfinder: Dietrich, Peter, 63322 Rödermark (DE)
(74) Vertreter: Gille Hrabal

(57) **Zusammenfassung**

Beschrieben wird ein Metall-Isolator-Substrat, dass eine Strukturierung der Metallisierung zur direkten Kühlung vorsieht. Des Weiteren wird ein Verfahren zur Herstellung dieses Metall-Isolator-Substrats beschrieben.

## Beschreibung

Die vorliegende Erfindung betrifft ein Metall-Keramik-Substrat mit einer direkten Kühlung. Weiterer Gegenstand der vorliegenden Erfindung ist ein Verfahren zur Herstellung und die Verwendung des erfindungsgemäßen Metall-Keramik-Substrats.

### Stand der Technik

Metall-Keramik-Substrate, insbesondere solche in Form von Leiterplatten für elektrische und elektronische Schaltkreise oder Module, sowie Verfahren zur Herstellung derartiger Metall-Keramik-Substrate sind allgemein bekannt. In der Regel bestehen diese Substrate aus einer keramischen Isolierschicht, die an ihren beiden Oberflächenseiten jeweils mit einer Metallisierung versehen ist. Die Metallisierung wird in der Regel durch eine Metallfolie, z.B. aus Kupfer oder aus einer Kupferlegierung, gebildet, welche mit Hilfe eines geeigneten Verfahrens vollflächig mit der keramischen Isolierschicht verbunden wird.

Zum Erzeugen einer stabilen Verbindung zwischen dem Keramik-Substrat und der Metallfolie ist beispielsweise das DCB-Verfahren (*Direct-Copper-Bond-Verfahren*) bekannt. Bei diesem DCB-Verfahren zum Verbinden von Kupferfolien und Keramik wird das Kupfer der Kupferfolie zunächst oberflächlich zu Kupferoxid (Cu₂O) oxidiert. Der Schmelzpunkt von Kupferoxid (Cu₂O) ist geringer als der Schmelzpunkt von reinem Kupfer und die mit Kupferoxid beschichtete Kupferfolie wird auf die Oberfläche des Keramik-Substrats gelegt und in einem Ofen erwärmt. In der Schmelze fügt sich die untere Seite der Kupferfolie, die aus Kupferoxid besteht, mit der Keramikoberfläche zusammen. Dieses DCB-Verfahren weist im Allgemeinen die folgenden Verfahrensschritte auf:
(a) Oberflächliches Oxidieren einer Kupferfolie derart, dass sich eine gleichmäßige Kupferoxidschicht bildet;
(b) Auflegen der Kupferfolie auf die Keramikschicht;
(c) Erhitzen des Verbundes auf eine Prozesstemperatur zwischen etwa 1025 bis 1083 °C; und
(d) Abkühlen auf Raumtemperatur.

Analog zu diesem vorgenannten DCB-Verfahren zum direkten Verbinden von Kupfer und Keramik (auch als *direct bonding* bezeichnet) sind noch andere Verfahren- oder Technologien bekannt, mit denen in analoger Weise das Verbinden von Metallschichten mit Keramiken oder Keramikschichten möglich ist.

Bekannt ist beispielsweise das sogenannte Aktivlot-Verfahren zum Verbinden von Metallisierungen bildenden Metallschichten oder Metallfolien, insbesondere auch von Kupferschichten oder Kupferfolien oder Aluminiumschichten oder Aluminiumfolien, mit einem Keramikmaterial. Bei diesem Verfahren wird bei einer Temperatur in der Regel zwischen 800 und 1000 °C eine Verbindung zwischen einer Metallfolie, beispielsweise Kupferfolie, und einem Keramiksubstrat, beispielsweise einer Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

Eine weitere Möglichkeit der Herstellung von Metall-Keramik-Substraten ist durch die in der WO 2017/108939 A beschriebene Verfahrensweise gegeben, nach welcher eine Dickfilmpaste entweder auf das Keramik-Substrat oder die Metallfolie appliziert wird und anschließend das Keramiksubstrat und die Metallfolie miteinander verbunden werden.

Das DCB-Verfahren und die übrigen Verfahren zur Herstellung von Metall-Keramik-Substraten, wie insbesondere das AMB-Verfahren und das TFCB-Verfahren, werden allgemein als MCS-Verfahren (*MCS* = *metal ceramic substrate*) bezeichnet. In der vorliegenden Erfindung wird der Begriff Metall-Isolator-Substrat und Metall-Keramik-Substrat (MCS) synonym verwendet.

Die Anwendungsbereiche von Metall-Keramik-Substraten reichen von Anwendungen im Bereich Automotive über Anwendungen im Bereich von Windkraftanlagen bis zu Anwendungen im Bereich der Sensorik, also überall dort, wo Module in großen Temperaturbereichen und unter sehr hohen Strömen und Strompulsen dauerhaft funktionstüchtig bleiben müssen. Sie finden sich beispielsweise in IGBT- oder Mosfet-Transistormodulen, in Frequenzumrichtern oder in Stromumrichtern wieder. Mit einem Wärmeausdehnungskoeffizienten nahe dem von Silizium eignen sie sich für Chip-on-Board-Verbindungen. Die beim Schalten der Bauteile erzeugte Wärme muss jedoch über das Substrat abgeführt werden, was zunächst durch die hohe Wärmeleitfähigkeit der Keramik, kombiniert mit der hohen Wärmekapazität und Wärmespreizung des Kupfers, möglich wird.

Bei den bekannten Metall-Keramik-Substraten bildet die "zweite" Metallisierung, d.h. die die elektronischen Schaltkreise bildende Metallisierung gegenüberliegende Metallisierung, in der Regel eine Zwischenschicht, die insbesondere eine Anbindung an eine metallische Grundplatte ermöglicht und einen verbesserten thermischen Übergang zwischen der Keramikschicht und dieser metallischen Grundplatte bewirkt, auf der das Metall-Keramik-Substrat angeordnet ist und die ihrerseits mit einem Kühlkörper oder einer Wärmesenke verbunden ist. Die Verbindung zwischen dem Metall-Keramik-Substrat und der Grundplatte ist beispielsweise eine Löt- oder Sinterverbindung.

Entsprechende mit separaten Kühlkörpern versehene Metall-Keramik-Substrate sind beispielsweise aus der Druckschrift EP 0 751 570 A bekannt, in welcher beschrieben wird, dass der Kühlkörper unter ein Metall-Keramik-Substrat verschraubt wird.

Auch die Druckschrift US 5,847,929 betrifft ein Metall-Keramik-Substrat, in welchem ein separater Kühlkörper über eine Silikon-haltige Klebeschicht an das Metall-Keramik-Substrat angebunden ist.

Die Druckschrift DE 10 2009 045 063 A beschreibt ein Metall-Keramik-Substrat mit einem separaten angespritzen Kühlkörper.

Die Druckschrift US 2012/0282454 A betrifft ein Metall-Keramik-Substrat mit einem separaten aus einem Schaummaterial bestehenden Kühlkörper.

Die Druckschrift US 5,200,641 beschreibt ein Metall-Keramik-Substrat, in welchem auf der Metallschicht ein separater komplexer Verbundkörper, ebenfalls als Kühlkörper, verwendet wird.

In der Zwischenzeit wird insbesondere bei Automotiv-Anwendungen und Traktions-Anwendungen (Anwendungen im Bereich der Bahntechnik) eine direkte Kühlung der Metall-Keramik-Substrate bevorzugt. Hierbei wird anstelle einer flachen Bodenplatte ein Kühlkörper verwendet, bei dem die Unterseite entsprechend so ausgeprägt ist, dass er mit einem Kühlmedium direkt umspült werden kann. Dieser Kühlkörper ist über die Metallisierung des Metall-Keramik-Substrats mit dem Keramiksubstrat verbunden (d.h. die Bodenplatte ist direkt mit einer Kühlerstruktur ausgebildet). Auf diese Weise wird der thermische Pfad um die Anbindung Bodenplatte zu Kühler mittels thermischer Leitpaste verkürzt und Wärmleitpasten sind nicht mehr notwendig. Es ist zwar richtig, dass die Zuverlässigkeit der resultierenden Metall-Keramik-Substrate durch die direkte Kühlung verbessert wird, da die Wärmeleitpaste durch Beweglichkeit, Alterung und Pumpout-Effekt ein zusätzliches Risiko darstellt, allerdings ist die Herstellung entsprechender Leistungsmodule aufgrund Verwendung von separater Metallisierung und strukturierter Bodenplatte aufwendig.

Darüber hinaus haben sich in den letzten Jahren insbesondere bei Anwendungen im Bereich Automotive Leistungshalbleitermodule mit Metall-Keramik-Substraten mit indirekter Kühlung (mit Wärmeleitpasten) durchgesetzt. Entsprechende Metall-Keramik-Substrate sind modular einsetzbar und bieten durch die Materialeinsparung Vorteile bezüglich Kosten und Gewicht.

Ebenso haben sich Leistungshalbleitermodule durchgesetzt, die anstelle einer Keramik als elektrischer Isolator eine organische Zwischenschicht besitzen. Bei der organischen Zwischenschicht kann es sich beispielsweise um eine dielektrische Isolationsfolie handeln, wie sie in dem Leistungsmodul gemäß DE 10 2011 088 218 A1 verwendet wird. Hierbei wird die dielektrische Isolationsfolie mittels Klebstoffschichten auf einen Kühlkörper fixiert. Diese Ausführungsform des Standes der Technik verzichtet zwar auf eine Bodenplatte, erfordert aber eine separate Klebstoffschicht und einen separaten Kühlkörper.

Ausgehend von diesem Stand der Technik stellt sich die vorliegende Erfindung die Aufgabe, Metall-Isolator-Substrate bereitzustellen, die einen einfacheren Aufbau aufweisen und trotzdem effektiv gekühlt werden können.

Diese Metall-Isolator-Substrate sollen vorzugsweise eine kostengünstige Herstellung von entsprechenden Leistungsmodulen ermöglichen.

Darüber hinaus sollen diese Metall-Isolator-Substrate vorzugsweise eine kompakte Bauform aufweisen und insbesondere auf die herkömmlich verwendeten verhältnismäßig großen Kühler (oder Wärmesenken) verzichten können.

Die vorstehenden Aufgaben werden erfindungsgemäß durch ein Metall-Isolator-Substrat, umfassend
a. ein Isolatorsubstrat mit einer Oberseite und einer Unterseite;
b. eine erste Metallisierung auf der Oberseite des Isolatorsubstrats, die für die Ausbildung einer Schaltungselektronik bestimmt ist oder mit mindestens einer Schaltungselektronik versehen ist; und
c. eine zweite Metallisierung auf der Unterseite des Isolatorsubstrats
gelöst, wobei die zweite Metallisierung des erfindungsgemäßen Metall-Isolator-Substrats als Kühlkörper ausgebildet ist.

Erfindungsgemäß ist also vorgesehen, dass die der Schaltungselektronik gegenüberliegende Metallisierung des Isolatorsubstrats unmittelbar als Kühlkörper oder Wärmesenke fungiert. Eine Anbindung eines separaten Kühlkörpers, beispielsweise über eine metallische Grundplatte, oder aber die Verwendung einer als Kühlkörper ausgebildeten Grundplatte ist im Rahmen der vorliegenden Erfindung vorzugsweise nicht vorgesehen.

Im Rahmen der vorliegenden Erfindung wird unter einer als Kühlkörper ausgebildeten Metallisierung eine Metallisierung verstanden, die eine aktive Kühlung des Metall-Isolator-Substrats ermöglicht; unter einer aktiven Kühlung wird wiederum vorzugsweise verstanden, dass sich die Metallisierung in einem unmittelbaren Kontakt mit einem Kühlmedium befindet. Das Kühlmedium ist, wie noch weiter unten näher ausgeführt, vorzugsweise flüssig oder gasförmig, weiter bevorzugt flüssig.

Bevor nun die vorliegende Erfindung näher beschrieben wird, werden nachfolgende Begrifflichkeiten der vorliegenden Erfindung näher erläutert.

Das erfindungsgemäße Metall-Isolator-Substrat weist mindestens eine Metallisierung auf der Oberseite und mindestens eine Metallisierung auf der Unterseite des Isolatorsubstrats auf. Die Verwendung der Begriffe Ober- und Unterseite des Isolatorsubstrats stellt keine räumliche Bevorzugung für Flächen des Metall-Isolator-Substrats dar, sondern dient nur zur Differenzierung der beiden Flächen des Isolatorsubstrats. Diese beiden Flächen des Isolatorsubstrats, auf denen die beiden Metallisierungen vorgesehen sind, sind zueinander gegenüberliegend angeordnet und stellen in der Regel die flächenmäßig größten Flächen des Isolatorsubstrats dar.

Die erste Metallisierung auf der einen Seite des Isolatorsubstrats, vorliegend als Oberseite des Isolatorsubstrats bezeichnet, dient zur Ausbildung der Schaltungselektronik. Beispielsweise sind Leistungs- und Logikbausteine, aber auch Strukturierungen von Leiterbahnen und Kontaktflächen und/oder Befestigungsflächen für elektronische Bauteile, auf dieser ersten Metallisierung vorgesehen.

Die zweite Metallisierung auf der anderen Seite des Isolatorsubstrats (gegenüberliegend zur ersten Metallisierung), vorliegend als Unterseite des Isolatorsubstrats bezeichnet, dient zur direkten Kühlung des Metall-Isolator-Substrats.

Die vorliegende Erfindung sieht somit vor, dass der Kühlkörper integraler Bestandteil des Metall-Isolator-Substrats ist; damit wird im Rahmen der vorliegenden Erfindung auf einen separat ausgebildeten Kühlkörper, mit welchem das Metall-Isolator-Substrat verbunden wird, in der Regel verzichtet. Eine besondere Ausführungsform der vorliegenden Erfindung umfasst somit keinen separaten ausgebildeten Kühlkörper, mit welchem das Metall-Isolator-Substrat verbunden wird.

Die Isolationsschicht des erfindungsgemäßen Metall-Isolator-Substrats unterliegt keinen Beschränkungen, solange die Isolationsschicht als ausreichendes Dielektrikum fungiert.

Die Isolationsschicht, die zwischen der ersten und zweiten Metallisierung vorliegt, kann in einer ersten Ausgestaltung eine Keramikschicht sein (Keramiksubstrat). In diesem Fall resultiert ein Metall-Keramik-Substrat.

In einer zweiten Ausgestaltung der vorliegenden Erfindung handelt es sich bei der Isolationsschicht um ein Metallsubstrat, dass mit organischem Isolator beschichtet ist, wie beispielsweise von der Firma Mitsubishi Electric Corporation vertrieben.

In einer dritten Ausgestaltung der vorliegenden Erfindung kann es sich um eine Kunststoff-Isolationsschichtschicht, beispielsweise um eine Kunststofffolie, handeln.

Leistungsmodule, umfassend die erfindungsgemäßen Metall-Isolations-Substrate, sind in der Herstellung kostengünstiger, da auf die separate Herstellung eines Kühlkörpers und dem Arbeitsschritt des Verbindens von Metall-Isolator-Substrat und Kühlkörper verzichtet werden kann.

Die Schichtdicke der zweiten Metallisierung mit der Kühlstruktur beträgt maximal mehrere Hunderte µm, so dass das resultierende erfindungsgemäße Metall-Isolator-Substrat mit direkter Kühlung in der konkreten Anwendung einen deutlich geringeren Platzbedarf aufweist als ein herkömmliches Metall-Isolator-Substrat mit einem separaten Kühler.

Im Folgenden werden bevorzugte Ausführungsformen des erfindungsgemäßen Metall-Isolator-Substrats beschrieben.

In einer ersten Ausführungsform der vorliegenden Erfindung wird ein wie vorstehend beschriebenes Metall-Isolator-Substrat beansprucht, also ein Isolatorsubstrat mit auf beiden Seiten des Isolatorsubstrats vorgesehenen Metallisierungen, wobei ein Kühlmedium in Kontakt mit einer der beiden Metallisierungen steht. Dieses Kühlmedium kann gasförmig oder flüssig, jedoch bevorzugt flüssig, sein.

In einer zweiten Ausführungsform ist die zweite Metallisierung zur direkten Kühlung mit einer Strukturierung versehen. Diese Strukturierung dient dazu, die zur Kühlung zur Verfügung stehende Fläche der zweiten Metallisierung - im Vergleich zu einer planaren Struktur der zweiten Metallisierung - zu vergrößern, so dass eine Kühlung durch ein mit dieser Oberfläche in Kontakt stehendes Kühlmedium effizient ermöglicht wird. Dieses Kühlmedium kann gasförmig oder flüssig, jedoch bevorzugt flüssig, sein. Die Strukturierung der zweiten Metallisierung zur direkten Kühlung kann auch dergestalt ausgebildet sein, dass an einigen Stellen die zweite Metallisierung vollständig entfernt wird und das verwendete Kühlmedium an diesen Stellen somit bis zum Isolatorsubstrat reicht. Eine Ausführungsform, bei welcher das Kühlmedium bis an das Isolatorsubstrat reicht, kann sich zum Beispiel dann ergeben, wenn die zweite Metallisierung aus einer vorstrukturierten, beispielsweise gestanzten, Metallfolie gebildet wird, aus welcher ein Teil der Metallsierungen aus der ursprünglichen Metallfolienebene entfernt wurde. Darüber hinaus ist auch eine Ausführungsform von der vorliegenden Erfindung umfasst, in welcher ein Teil der Metallisierungen aus der ursprünglichen Metallfolienebene hervorstehend ausgeprägt ist.

In einer bevorzugten Ausgestaltung dieser Strukturierung auf der abgewandten Seite der Schaltungselektronik (zweite Metallisierung) ist eine Strukturierung dergestalt vorgesehen, dass Strömungs- und/oder Kühlkanäle erzeugt werden, durch die ein Kühlmedium hindurchfließen kann. Diese Strömungs- oder Kühlkanäle werden dabei von der zweiten Metallisierung bzw. dem Isolatorsubstrat (bei partieller Entfernung der Metallisierung) begrenzt und ragen in ein geschlossenes System, beispielsweise aus Metall, welches mit Anschlüssen für das Kühlmedium versehen ist.

In einer bevorzugten Ausführungsform wird die zweite Metallisierung aus einer Kupfer- oder Aluminium umfassenden Folie, bevorzugt einer Kupferfolie gebildet, in welche die Kühlstrukturen eingeprägt oder eingestanzt sind.

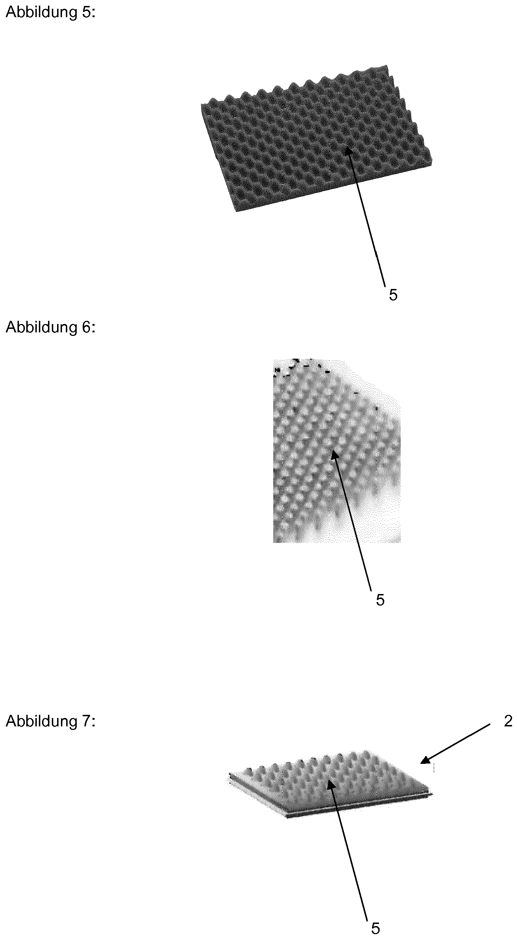

In einer weiteren Ausgestaltung der Strukturierung der zweiten Metallisierung des erfindungsgemäßen Metall-Isolator-Substrats ist eine konkav-konvexe Struktur vorgesehen; eine entsprechende Darstellung dieser Strukturierung der zweiten Metallisierung auf der dem Isolatorsubstrat abgewandten Seite ist in der Abbildung 5 dargestellt.

In einer weiteren Ausgestaltung der Strukturierung der zweiten Metallisierung des erfindungsgemäßen Metall-Isolator-Substrats sind Nadeln vorgesehen.

Eine weitere Ausgestaltung der Strukturierung der zweiten Metallisierung des erfindungsgemäßen Metall-Isolator-Substrats sieht eine Pin-Fin-Struktur vor; eine entsprechende Darstellung dieser Strukturierung der zweiten Metallisierung auf der dem Isolatorsubstrat abgewandten Seite ist in der Abbildung 6 dargestellt.

Die Herstellung von Metall-Isolator-Substraten erfolgt in der Regel durch einen *Direct-Metal-*Bond-Prozess in einem Bondofen; die entsprechenden Verfahrensschritte sind bereits vorstehend in ihren Grundzügen erläutert und dem Fachmann auf dem zugrundeliegenden technischen Gebiet bekannt. Die Metallisierungen auf den beiden Seiten des Isolatorsubstrats erfolgt dabei in der Regel ausgehend von einer Metallfolie. Daher ist es im Rahmen der vorliegenden Erfindung vorzugsweise vorgesehen, dass die zweite Metallisierung, die zur Ausbildung der direkten Kühlstruktur dient, ebenfalls durch eine Folie gebildet wird.

Die zweite Metallisierung, die die zur Kühlung verwendete Strukturierung umfassen kann, weist in der Regel eine Schichtdicke von 100 bis 1500 µm, bevorzugt 150 bis 1200 µm, noch weiter bevorzugt 200 bis 800 µm, auf.

Einzelne Bereiche der zweiten Metallisierung können dabei, wie bereits erwähnt, vollständig entfernt oder zumindest aus der ursprünglichen Metallfolienebene hervorstehend ausgeprägt sein. In diesem Fall ist die zweite Metallisierung diskontinuierlich auf der Unterseite des Isolatorsubstrats aufgebracht.

Alternativ kann die zweite Metallisierung auf dem Isolatorsubstrat auch vollflächig verbleiben, d.h. die Strukturierungen zur direkten Kühlung, die in diesem Fall nur durch einen teilweisen Abtrag der Metallisierung gebildet werden, erstrecken sich nicht bis zum Isolatorsubstrat. In diesem Fall ist somit vorgesehen, dass die zweite Metallisierung kontinuierlich auf der Unterseite des Isolatorsubstrats aufgebracht ist.

Eine diskontinuierliche Aufbringung der zweiten Metallisierung mit Ausnehmungen in der zweiten Metallisierung ist bevorzugt.

Bei dem erfindungsgemäßen Metall-Isolator-Substrat kann es sich um eine DCB-Anordnung, eine DAB-Anordnung, eine AMB-Anordnung oder eine TFCB-Anordnung handeln.

### DCB-Anordnung:

Bei der DCB-Anordnung (auch DBC-Anordnung) wird eine Kupferfolie (als erste und zweite Metallisierung) unmittelbar auf ein Keramiksubstrat (als Isolatorsubstrat) mit dem bekannten DCB-Verfahren aufgebondet; in diesem Fall kann die zweite Kupfer-Metallisierung auf der Unterseite des Keramiksubstrats bereits zur direkten Kühlung vorstrukturiert sein oder nach dem Bonden mit einer Strukturierung zur direkten Kühlung versehen sein.

### DAB-Anordnung:

Bei der DAB-Anordnung (auch DBA-Anordnung) wird eine Aluminiumfolie als erste und zweite Metallisierung unmittelbar auf ein Keramiksubstrat (als Isolatorsubstrat) mit dem bekannten DAB-Verfahren aufgebondet; in diesem Fall kann die zweite Aluminium-Metallisierung auf der Unterseite des Keramiksubstrats bereits zur direkten Kühlung vorstrukturiert sein oder nach dem Bonden mit einer Strukturierung zur direkten Kühlung versehen sein.

### AMB-Anordnung:

Bei einer AMB-Anordnung (auch AMC-Anordnung) wird eine Metallisierung, beispielsweise eine Kupfermetallisierung, als erste und zweite Metallisierung auf ein Keramiksubstrat (als Isolatorsubstrat) aufgelötet, wobei in der Regel ein Metall, beispielsweise Titan, zu der Lötzusammensetzung hinzugefügt wird. Das Auflöten der zweiten Metallisierung auf das Keramiksubstrat kann beispielsweise zunächst vollflächig mit einer anschließenden Strukturierung zur direkten Kühlung erfolgen oder aber der Auflötprozess der Metallisierung kann bereits unter Ausbildung der Strukturierung zur direkten Kühlung erfolgen.

### TFCB-Anordnung:

Bei einer TFCB-Anordnung wird ein Keramiksubstrat (als Isolatorsubstrat) verwendet, wobei die Metallisierungen über eine Dickschichtfilmpaste, beispielsweise enthaltend ein Metall und Bi₂O₃ oder ein Metall und gegebenenfalls ein Glasmaterial, mit dem Keramiksubstrat verbunden werden. Auch in diesem Fall kann die als zweite Metallisierung auf der Unterseite des Keramiksubstrats zur direkten Kühlung vorgesehene Metallisierung vor oder nach dem Verbinden mit dem Isolationssubstrat zur direkten Kühlung strukturiert werden. Entsprechende Metall-Isolator-Substrate sind aus der WO 2017/108939 A bekannt, dessen diesbezügliche Offenbarung durch Bezugnahme in die vorliegende Erfindung eingeschlossen wird.

Bei diesen Anordnungen ist üblicherweise vorgesehen, dass die zweite Metallisierung unmittelbar auf dem Isolatorsubstrat, gegebenenfalls über eine Aktivlotverbinung (AMB) oder eine Dickschichtfilmpaste (TFCB), aufgebracht ist. Die Herstellung dieser erfindungsgemäßen Metall-Isolator-Substrate erfolgt nach den oben beschriebenen und dem Fachmann bekannten Verfahren des Bondens.

Das erfindungsgemäße Metall-Isolator-Substrat weist in diesen Fällen üblicherweise ein Keramiksubsutrat auf, das üblicherweise ausgewählt aus der Gruppe, bestehend aus Aluminiumoxid, Aluminiumnitrid, Siliziumnitrid, Siliziumcarbid und einer Mischkeramik aus Aluminiumoxid oder Aluminiumnitrid und Zirkonoxid, auf.

Im Rahmen der vorliegenden Erfindung kann das Isolatorsubstrat aber auch von einem Keramiksubstrat abweichen und beispielsweise durch eine Kunststofffolie oder durch ein mit Harz beschichtetes Metallsubstrat gebildet werden. Bei diesen Anordnungen handelt es sich beispielsweise um eine ISS-Anordnung.

### ISS-Anordnung:

Bei der ISS-Anordnung werden Metallfolien als erste und zweite Metallisierung mit einer Kunststofffolie oder einem mit Harz beschichteten Metallsubstrat (als Isolatorsubstrat) durch beispielsweise eine Klebeschicht verbunden. In diesem Fall kann die zweite Metallisierung auf der Unterseite der Kunststofffolie bzw. dem beschichteten Metallsubstrat bereits zur direkten Kühlung vorstrukturiert sein oder nach dem Verbinden mit einer Strukturierung zur direkten Kühlung versehen sein.

Das erfindungsgemäße Metall-Isolator-Substrat wird üblicherweise in einem umschließenden Gehäuse angeordnet, wobei das Gehäuse im Allgemeinen zusätzlich ein Kühlmedium umfasst.

Das zum Kühlen des erfindungsgemäßen Metall-Isolator-Substrats verwendete Kühlmedium, dass die zweite Metallisierung insbesondere an der erzeugten Strukturierung umströmt, kann flüssig oder gasförmig sein, bevorzugt jedoch flüssig..

Das erfindungsgemäße Metall-Isolator-Substrat weist darüber hinaus üblicherweise eine erste Metallisierung auf. Diese erste Metallisierung auf der der zweiten Metallisierung gegenüberliegenden Seite des Isolatorsubstrats weist üblicherweise Schaltungselektronik, beispielsweise Strukturierungen zur Ausbildung von mindestens einem Leistungs- und/oder Logikteil, Strukturierungen von Leiterbahnen, Strukturierung von Kontaktflächen und/oder Befestigungsflächen für elektrische Bauelemente, auf.

Ein weiterer Gegenstand der vorliegenden Erfindung ist ein Verfahren zur Herstellung des erfindungsgemäßen Metall-Isolator-Substrats, umfassend
a. ein Isolatorsubstrat mit mindestens einer Oberseite und mindestens einer Unterseite;
b. eine erste Metallisierung auf der Oberseite des Isolatorsubstrats, die für die Ausbildung einer Schaltungselektronik bestimmt ist oder mit mindestens einer Schaltungselektronik versehen ist; und
c. eine zweite Metallisierung auf der Unterseite des Isolatorsubstrats.

Das erfindungsgemäße Verfahren ist durch mindestens die folgenden Verfahrensschritte gekennzeichnet
1. Bereitstellen eines Isolatorsubstrats mit mindestens einer Oberseite und mindestens einer Unterseite; und
2. Aufbringen der zweiten Metallisierung auf der Unterseite des Isolatorssubstrats,
wobei die zweite Metallisierung bereits bei dem Aufbringen eine zur direkten Kühlung geeignete Strukturierung aufweist oder nach dem Aufbringen auf das Isolatorsubstrat die zweite Metallisierung mit einer Strukturierung zur direkten Kühlung versehen wird.

Entsprechende Metall-Isolator-Substrate sind bereits vorstehend näher beschrieben worden (DCB-, DAB-, AMB-, TFCB- und ISS-Anordnungen); es wird auf die vorherigen Ausführungen verwiesen.

Die in diesem Verfahren aufgetragene Metallisierung ist im Sinne der vorliegenden Erfindung die zweite Metallisierung, die - wie vorstehend beschrieben - zur direkten Kühlung des Metall-Isolator-Substrats dient.

Wenn in dem erfindungsgemäßen Verfahren eine Metallfolie verwendet wird, die noch unstrukturiert ist und nach dem Bonden die resultierende Metallisierung strukturiert wird, so kann die Strukturierung durch ein Prägen, Stanzen und/oder Biegen erfolgen.

Wenn in dem erfindungsgemäßen Verfahren eine Metallfolie verwendet wird, die schon strukturiert ist, so kann die Strukturierung vor der Aufbringung auf dem Isolatorsubstrat in der Metallfolie ebenfalls durch ein Prägen, Stanzen und/oder Biegen erfolgen.

Parallel zum Erzeugen der zweiten Metallisierung (vorstrukturiert oder unstrukturiert) auf der Unterseite des Isolatorsubstrats kann auf der Oberseite des Isolatorsubstrats eine Metallisierung durch ein Bondprozess erfolgen, auf welcher anschließend entsprechende Schaltungselektronik vorgesehen wird.

Darüber hinaus betrifft die vorliegende Erfindung die Verwendung des zuvor beschriebenen Metall-Isolator-Substrats in der Schaltungselektronik sowie ein Leistungshalbleitermodul, dass das zuvor beschriebene Metall-Isolator-Substrat umfasst.

Diese Verwendung ist insbesondere dadurch gekennzeichnet, dass die Kühlung durch ein Medium erfolgt, dass in unmittelbarem Kontakt mit der zweiten Metallisierung steht; sollte die zweite Metallisierungen Strukturierungen zur direkten Kühlung aufweisen, die durch Ausnehmungen in der zweiten Metallisierung gebildet werden, steht das verwendete Kühlmedium auch in einem direkten Kontakt mit dem Isolatorsubstrat oder einem Material, dass zur Verbindung der zweiten Metallisierung mit dem Isolatorsubstrat verwendet wird.

Die vorliegende Erfindung wird in anhand der nachfolgenden Abbildungen näher erläutert. In diesen Abbildungen werden die folgenden Bezugszeichen verwendet:
1: Erfindungsgemäßes Metall-Isolator-Substrat
2: Isolator-Substrat
3: erste Metallisierung
4: zweite Metallisierung
5: Strukturierung der zweiten Metallisierung
6: Zwischenschicht bei einem erfindungsgemäßen Metall-Isolator-Substrat, das nach dem TFCB-Verfahren hergestellt wird
7: Zwischenschicht bei einem erfindungsgemäßen Metall-Isolator-Substrat, das nach dem AMB-Verfahren hergestellt wird
8. Zwischenschicht bei einem erfindungsgemäßen Metall-Isolator-Substrat, das durch Löten, Sintern oder Kleben hergestellt wird
9: Dichtung
10: Gehäuse

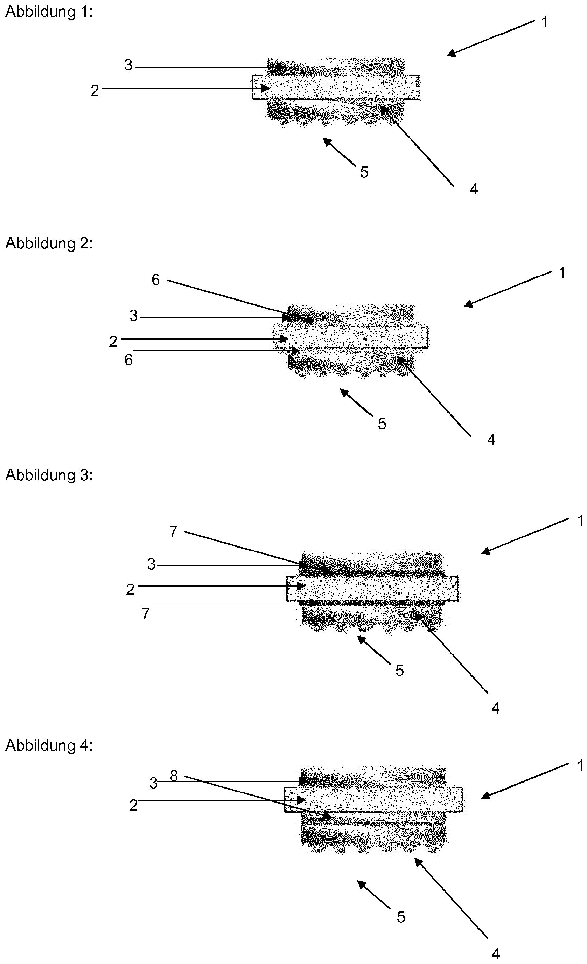

Die Abbildung 1 zeigt ein erfindungsgemäßes Metall-Isolator-Substrat 1, das auf einem Isolatorsubstrat 2 eine erste und eine zweite Metallisierung 3, 4 aufgebracht aufweist. Die erste Metallisierung 3 dient der Aufnahme von nicht dargestellter Schaltungselektronik, während die zweite Metallisierung 4 eine Strukturierung 5 zur direkten Kühlung aufweist. Bei diesem Metall-Isolator-Substrat 1 handelt es sich um eine Anordnung, die nach dem DCB-Verfahren hergestellt wird.

Die Abbildung 2 zeigt ein erfindungsgemäßes Metall-Isolator-Substrat 1, das auf einem Isolatorsubstrat 2 eine erste und eine zweite Metallisierung 3, 4 aufgebracht aufweist. Die erste Metallisierung 3 dient der Aufnahme von nicht dargestellter Schaltungselektronik, während die zweite Metallisierung 4 eine Strukturierung 5 zur direkten Kühlung aufweist. Bei diesem Metall-Isolator-Substrat handelt es sich um eine Anordnung, die nach dem TFCB-Verfahren hergestellt wird und daher eine Zwischenschicht 6 zwischen dem Isolatorsubstrat und der ersten und zweiten Metallisierung aufweist. Die Zwischenschicht wird durch eine Dickschichtfilmpaste gebildet, die ein Metall und Bi₂O₃ oder ein Metall und gegebenenfalls ein Glasmaterial enthält. Im Rahmen der vorliegenden Erfindung kann die Zwischenschicht 6 zwischen dem Isolatorsubstrat 2 und beiden Metallisierungen 3, 4 oder nur zwischen dem Isolatorsubstrat 2 und der Metallisierung 3 oder 4 vorliegen.

Die Abbildung 3 zeigt ein erfindungsgemäßes Metall-Isolator-Substrat 1, das auf einem Isolatorsubstrat 2 eine erste und eine zweite Metallisierung 3, 4 aufgebracht aufweist. Die erste Metallisierung 3 dient der Aufnahme von nicht dargestellter Schaltungselektronik, während die zweite Metallisierung 4 eine Strukturierung 5 zur direkten Kühlung aufweist. Bei diesem Metall-Isolator-Substrat handelt es sich um eine Anordnung, die nach dem AMB-Verfahren hergestellt wird und daher eine Zwischenschicht 7 als Hartlot zwischen dem Isolatorsubstrat und der Metallisierung aufweist. Im Rahmen der vorliegenden Erfindung kann die Zwischenschicht 7 zwischen dem Isolatorsubstrat 2 und beiden Metallisierungen 3, 4 oder nur zwischen dem Isolatorsubstrat 2 und der Metallisierung 3 oder 4 vorliegen.

Die Abbildung 4 zeigt ein erfindungsgemäßes Metall-Isolator-Substrat 1, das auf einem Isolatorsubstrat 2 eine erste und eine zweite Metallisierung 3, 4 aufgebracht aufweist. Die erste Metallisierung 3 dient der Aufnahme von nicht dargestellter Schaltungselektronik, während die zweite Metallisierung 4 eine Strukturierung 5 zur direkten Kühlung aufweist. Bei diesem Metall-Isolator-Substrat handelt es sich um eine Anordnung, die allgemein durch Löten, Sintern oder Kleben hergestellt wird und daher eine entsprechende Zwischenschicht 8 zwischen dem Isolatorsubstrat und der zweiten Metallisierung aufweist. Im Rahmen der vorliegenden Erfindung kann die Zwischenschicht 8 zwischen dem Isolatorsubstrat 2 und beiden Metallisierungen 3, 4 oder nur zwischen dem Isolatorsubstrat 2 und der Metallisierung 3 oder 4 vorliegen. In der Abbildung 4 liegt die Zwischenschicht 8 nur zwischen dem Isolatorsubstrat und der

Die Abbildung 5 zeigt eine mögliche Strukturierung 9 eines erfindungsgemäßen Metall-Isolator-Substrats 1 an der zweiten Metallisierung 4 auf der dem Isolatorsubstrat 2 abgewandten Seite. Die Strukturierung 9 ist so ausgebildet, das eine konkav-konvexe Struktur resultiert. Das Kühlmedium, das in der vorliegenden Abbildung nicht dargestellt ist, fließt entlang der konkav-konvexen Struktur und kühlt das Metall-Isolator-Substrat 1.

Die Abbildung 6 zeigt eine mögliche Strukturierung 9 eines erfindungsgemäßen Metall-Isolator-Substrats 1 an der zweiten Metallisierung 4 auf der dem Isolatorsubstrat 2 abgewandten Seite. Die Strukturierung 9 ist so ausgebildet, das eine Pin-Fin Struktur resultiert. Das Kühlmedium, das in der vorliegenden Abbildung nicht dargestellt ist, fließt entlang der Pin Fin Struktur und kühlt das Metall-Isolator-Substrat 1.

Die Abbildung 7 zeigt eine mögliche Strukturierung 9 eines erfindungsgemäßen Metall-Isolator-Substrats 1 an der zweiten Metallisierung 4 auf der dem Isolatorsubstrat 2 abgewandten Seite. Die Strukturierung 9 ist so ausgebildet, das eine Noppenstruktur resultiert. Das Kühlmedium, das in der vorliegenden Abbildung nicht dargestellt ist, fließt entlang der Noppenstruktur und kühlt das Metall-Isolator-Substrat 1.

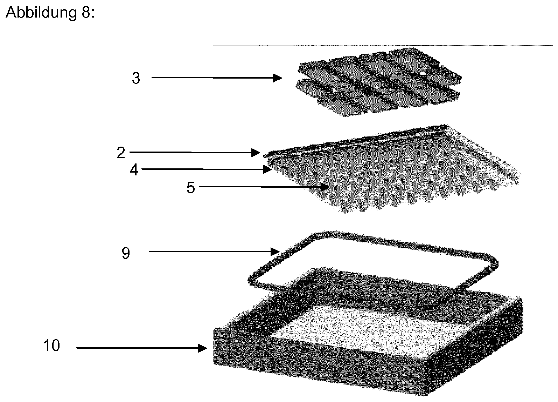

Die Abbildung 8 zeigt eine schematischen dreidimensionalen Aufbau eines erfindungsgemäßen Leistungshalbleitermodul. Dargestellt ist die erste Metallisierung 3, die nunmehr für die Aufnahme von Leistungselektronik strukturiert ist, das Isolatorsubstrat 2 sowie die zweite Metallisierung 4, die auf der Unterseite eine noppenartige Strukturierung aufweist. Das erfindungsgemäße Metall-Isolator-Substrat 1 ist in ein Gehäuse 10 eingebracht und mit einer Dichtung 9 versehen. Das Gehäuse 10 weist Öffnungen zum Einlass und/oder Auslass des Kühlmediums auf, die nicht dargestellt sind.

## Patentansprüche

1. Metall-Isolator-Substrat (1), umfassend
a. ein Isolatorsubstrat (2) mit mindestens einer Oberseite und mindestens einer Unterseite;
b. eine erste Metallisierung (3) auf der Oberseite des Isolatorsubstrats (2), die für die Ausbildung einer Schaltungselektronik bestimmt ist oder mit mindestens einer Schaltungselektronik versehen ist; und
c. eine zweite Metallisierung (4) auf der Unterseite des Isolatorsubstrats (2);
**dadurch gekennzeichnet, dass**
die zweite Metallisierung (4) als Kühlkörper ausgebildet ist.

2. Metall-Isolator-Substrat (1) nach Patentanspruch 1, **dadurch gekennzeichnet, dass** die zweite Metallisierung (4) auf der dem Isolatorsubstrat (2) abgewandten Seite eine Strukturierung (5) dergestalt aufweist, dass eine Kühlung durch ein Kühlmedium bewirkt werden kann.

3. Metall-Isolator-Substrat (1) nach Patentanspruch 1 oder 2, **dadurch gekennzeichnet, dass** die zweite Metallisierung (4) aus einer vorstrukturierten, insbesondere gestanzten, Metallfolie gebildet wird, aus welcher ein Teil der Metallsierungen aus der ursprünglichen Metallfolienebene entfernt wurde oder in welcher ein Teil der Metallisierungen aus der ursprünglichen Metallfolienebene hervorstehend ausgeprägt ist.

4. Metall-Isolator-Substrat (1) nach Patentanspruch 2 oder 3, **dadurch gekennzeichnet, dass** die zweite Metallisierung (4) auf der dem Isolatorsubstrat (2) abgewandten Seite so strukturiert ist, dass Strömungs- und/oder Kühlkanäle erzeugt werden.

5. Metall-Isolator-Substrat (1) nach einem der Patentansprüche 1 bis 4, **dadurch gekennzeichnet, dass** die zur Kühlung vorgesehene Strukturierung (5) der zweiten Metallisierung (4) nadelförmig ausgebildet ist, eine konkav-konvexe Struktur, eine Pin-Fin-Struktur, und/oder eine Rippenstruktur aufweist.

6. Metall-Isolator-Substrat (1) nach einem der Patentansprüche 1 bis 5, **dadurch gekennzeichnet, dass** die zweite Metallisierung (4) durch eine Metallfolie gebildet wird.

7. Metall-Isolator-Substrat (1) nach einem der Patentansprüche 1 bis 6, **dadurch gekennzeichnet, dass** die zweite Metallisierung (4) eine Schichtdicke von 200 bis 800 µm aufweist.

8. Metall-Isolator-Substrat (1) nach einem der Patentansprüche 1 bis 7, **dadurch gekennzeichnet, dass** das Metall-Isolator-Substrat (1) neben der Metallisierung (4) keinen weiteren Kühlkörper aufweist.

9. Metall-Isolator-Substrat (1) nach einem der Patentansprüche 1 bis 8, **dadurch gekennzeichnet, dass** das Metall-Isolator-Substrat (1) in einem umschließenden Gehäuse (10) angeordnet ist.

10. Metall-Isolator-Substrat (1) nach Patentanspruch 9, **dadurch gekennzeichnet, dass** das Gehäuse (10) zusätzlich ein Kühlmedium umfasst.

11. Leistungshalbleitermodul, umfassend mindestens ein der Metall-Isolator-Substrate (1) gemäß einem der Patentansprüche 1 bis 10.

12. Verfahren zur Herstellung von einem Metall-Isolator-Substrat (1), umfassend
a. ein Isolatorsubstrat (2) mit mindestens einer Oberseite und mindestens einer Unterseite;
b. eine erste Metallisierung (3) auf der Oberseite des Isolatorsubstrats (2), die für die Ausbildung einer Schaltungselektronik bestimmt ist oder mit mindestens einer Schaltungselektronik versehen ist; und
c. eine zweite Metallisierung (4) auf der Unterseite des Isolatorsubstrats (2); **gekennzeichnet, durch** mindestens die folgenden Verfahrensschritte:
1. Bereitstellen eines Isolatorsubstrats (2) mit mindestens einer Oberseite und mindestens einer Unterseite;
2. Bonden einer Metallfolie auf der Unterseite des Isolatorsubstrats (2),
wobei die Metallfolie vor dem Bonden bereits eine Strukturierung auf der dem Isolatorsubstrat (2) abgewandten Seite aufweist oder die Metallisierung nach dem Bonden einer Strukturierung (5) unterworfen wird.

13. Verfahren nach Patentanspruch 12, **dadurch gekennzeichnet, dass** die Strukturierung (5) der Metallisierung nach oder vor dem Verfahrensschritt des Bondens durch ein Prägen, Stanzen und/oder Biegen erfolgt.

14. Verwendung eines Metall-Isolator-Substrats (1) gemäß einem der Patentansprüche 1 bis 10 in der Schaltungselektronik.
